(19) **Europäisches Patentamt / European Patent Office / Office européen des brevets**

(11) **EP 3 149 830 B1**

(12) **FASCICULE DE BREVET EUROPEEN**

(45) Date de publication et mention
de la délivrance du brevet:
**04.07.2018 Bulletin 2018/27**

(21) Numéro de dépôt: **15731638.1**

(22) Date de dépôt: **19.05.2015**

(51) Int Cl.:
*H02J 7/00* (2006.01)　　*H02J 7/14* (2006.01)
*B60L 3/00* (2006.01)　　*B60L 11/14* (2006.01)
*B60L 15/20* (2006.01)　　*G01R 31/36* (2006.01)
*H01M 10/44* (2006.01)　　*H01M 10/48* (2006.01)
*B60L 11/18* (2006.01)　　*B60W 20/13* (2016.01)

(86) Numéro de dépôt international:
**PCT/FR2015/051297**

(87) Numéro de publication internationale:
**WO 2015/181465 (03.12.2015 Gazette 2015/48)**

(54) **PROCÉDÉ D'ESTIMATION DU TEMPS DE RÉHABILITATION DE LA PERFORMANCE D'UNE BATTERIE DE TRACTION D'UN VÉHICULE HYBRIDE**

VERFAHREN ZUR SCHÄTZUNG DER REHABILITATIONSZEIT DER LEISTUNG EINER TRAKTIONSBATTERIE EINES HYBRIDFAHRZEUGS

METHOD FOR ESTIMATION OF THE REHABILITATION TIME OF THE PERFORMANCE OF A TRACTION BATTERY OF A HYBRID VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.05.2014 FR 1454754**

(43) Date de publication de la demande:
**05.04.2017 Bulletin 2017/14**

(73) Titulaire: **Renault s.a.s**
**92100 Boulogne-Billancourt (FR)**

(72) Inventeurs:
• **SAINT-MARCOUX, Antoine**
**91120 Palaiseau (FR)**
• **FERREIRA-DE-ARAUJO, Manoela**
**94230 Cachan (FR)**

(56) Documents cités:
**US-A- 5 945 808　　US-A1- 2003 042 866**
**US-A1- 2008 284 378　　US-A1- 2008 311 466**

EP 3 149 830 B1

**Description**

La présente invention concerne un procédé d'estimation de la durée d'une phase de réhabilitation de la performance d'une batterie, celle-ci pouvant être une phase de charge d'une batterie.

L'invention s'applique préférentiellement à une batterie de traction d'un véhicule hybride équipé d'un groupe motopropulseur hybride, comprenant un moteur thermique et au moins une machine électrique destinés à assurer simultanément, ou indépendamment, la fourniture d'un couple au niveau des roues du véhicule. L'invention s'applique de manière non limitative à une batterie de traction mise en oeuvre dans une architecture de groupe motopropulseur hybride nécessitant, lors d'une phase de lancement ou « décollage » à partir de l'arrêt et aux faibles vitesses de déplacement du véhicule, que la puissance fournie au niveau des roues provienne exclusivement de la batterie de traction du véhicule. C'est le cas dans certaines architectures où, par construction, le moteur thermique ne peut intervenir dans la propulsion du véhicule qu'à partir d'une vitesse véhicule cible prédéterminée, de sorte que le groupe motopropulseur ne dispose que de l'énergie électrique stockée dans la batterie de traction du véhicule pour assurer le lancement et le déplacement du véhicule jusqu'à l'atteinte de ladite vitesse véhicule cible prédéterminée à laquelle le moteur thermique intervient.

Dans ce type d'architecture, pour éviter une immobilisation temporaire du véhicule, la batterie de traction doit donc toujours pouvoir fournir un niveau de puissance minimal requis permettant d'assurer le décollage du véhicule. A tout instant, la puissance disponible en décharge au niveau de la batterie dépend de son état de charge (plus la batterie est déchargée, moins elle pourra fournir de puissance), de sa température (plus la batterie est froide, moins elle pourra fournir de puissance) et de son état de vieillissement (plus la batterie est vieille, moins elle pourra fournir de puissance). Aussi, en pratique, il convient d'assurer que la batterie reste toujours à un niveau d'état de charge minimal et à un niveau de température minimal lui permettant d'assurer le niveau de puissance minimal requis. Pour ce faire, il est connu d'exploiter une loi de gestion de l'énergie dans le calculateur dédié à la gestion de la batterie, permettant de commander la recharge de la batterie dès qu'elle est trop déchargée, par exemple lorsque son état de charge passe sous un seuil critique, soit par l'activation d'un système de freinage récupératif, soit par l'activation d'un système de générateur lui-même entraîné par le moteur thermique du véhicule. La loi de gestion de l'énergie peut encore être conçue pour permettre de limiter la puissance fournie par la batterie de traction lorsque son état de charge devient proche d'un seuil minimal en deçà duquel elle ne pourra plus assurer le niveau de puissance minimal requis.

Dans certains cas d'usage extrême, la loi de gestion de l'énergie appliquée par le calculateur ne permet toutefois pas de maintenir la batterie dans des conditions qui lui permettront d'assurer le niveau de puissance minimal requis. Le véhicule se trouve alors potentiellement en situation d'immobilisation temporaire, dans laquelle la batterie de traction est incapable de fournir la puissance de traction requise pour assurer le décollage du véhicule à partir de l'arrêt et aux basses vitesses de déplacement du véhicule.

Le document de brevet FR2992274, au nom de la demanderesse, fait connaître un procédé de commande de la recharge d'une batterie de traction de véhicule hybride équipé d'un groupe motopropulseur hybride présentant les limitations telles qu'exposées ci-dessus, ce procédé prévoyant que, à l'arrêt forcé du véhicule, le moteur thermique entraîne la machine électrique fonctionnant en mode générateur pour recharger la batterie, tandis que le démarrage du véhicule est purement et simplement refusé tant que l'état de charge de la batterie n'est pas repassé au dessus d'un seuil lui permettant de fournir le niveau de puissance minimal requis.

Un inconvénient de ce système est que le véhicule est bloqué jusqu'à la réhabilitation des performances de la batterie de traction, autrement dit jusqu'à ce que cette dernière revienne à des conditions d'état de charge et de température lui permettant de fournir le niveau de puissance minimal requis. Le blocage du véhicule sur la route est certes temporaire, mais place néanmoins le conducteur dans une situation inconfortable et anxiogène, étant dans l'ignorance du temps de réhabilitation de la performance de la batterie au terme duquel la puissance minimale requise peut être fournie afin de redémarrer le véhicule.

Aussi, il existe un besoin pour pouvoir obtenir une estimation précise de la durée de cette phase de réhabilitation de la performance batterie et, en particulier, pour pouvoir estimer la durée d'une phase de charge d'une batterie de traction d'un véhicule hybride activée à l'arrêt pour amener cette batterie dans des conditions d'état de charge et de température lui permettant de fournir un niveau de puissance minimal requis.

Le document US 5 945 808 A divulgue un procédé de gestion de la puissance de charge d'une batterie présentant des inconvénients similaires.

Ce but est atteint grâce à un procédé d'estimation de la durée d'une phase de réhabilitation de la performance d'une batterie, caractérisé en ce qu'il comprend des étapes de :

- activation de la phase de réhabilitation de la performance batterie si la puissance disponible dans la batterie est inférieure à un niveau de puissance minimal requis, ladite phase permettant d'amener ladite batterie dans des conditions d'état de charge et de température lui permettant de fournir ledit niveau de puissance minimal requis,
- fourniture d'un modèle de fonctionnement de la batterie incluant, dans un plan (BSOC, T) où BSOC désigne l'état de charge de la batterie et où T désigne la température de la batterie, une courbe d'iso-puissance représentant dans ledit plan les points de fonctionnement de la batterie lui permettant de délivrer sensiblement ledit niveau de puissance minimal requis, ladite courbe séparant les points de fonctionnement permettant de délivrer un niveau de puissance supérieur au niveau de puissance minimal requis des points de fonctionnement ne lui permettant de délivrer qu'un niveau de puissance inférieur au niveau de puissance minimal requis,

- estimation de la durée de ladite phase de réhabilitation de la performance batterie à partir dudit modèle de fonctionnement fourni.

De préférence, ladite phase de réhabilitation de la performance batterie consiste en une phase de charge de la batterie.

Avantageusement, l'étape d'estimation de la durée de ladite phase de charge comprend des étapes de :

- déterminer la valeur du courant fourni à la batterie pendant ladite phase de charge ; et
- à partir d'un point de fonctionnement de la batterie défini par la température de la batterie et l'état de charge de la batterie à l'instant d'activation de la phase de charge, ledit point de fonctionnement ne permettant de délivrer qu'un niveau de puissance inférieur au niveau de puissance minimal requis, déterminer, en fonction dudit courant fourni à la batterie, la durée de ladite phase de charge comme étant le temps nécessaire pour amener le point de fonctionnement de la batterie sur ladite courbe d'iso-puissance.

De préférence, le procédé comprend l'étape de linéariser localement ladite courbe d'iso-puissance de façon à définir un seuil d'état de charge variant linéairement avec la température de batterie pour lequel la batterie est apte à fournir ledit niveau de puissance minimal requis, la durée de ladite phase de charge étant déterminée par rapport à ce seuil d'état de charge.

Avantageusement, la batterie est une batterie de traction d'un véhicule hybride comprenant un moteur thermique et au moins un moteur électrique, et en ladite phase de charge est réalisée en utilisant ledit au moins un moteur électrique en mode générateur.

De préférence, ledit niveau de puissance minimal requis correspond à la puissance de traction requise pour assurer le décollage du véhicule à partir de l'arrêt et aux basses vitesses de déplacement du véhicule jusqu'à une vitesse de véhicule cible prédéterminée.

Avantageusement, le procédé peut comprendre l'étape d'afficher la durée estimée de ladite phase de réhabilitation de la performance batterie.

Il est en outre proposé un produit programme d'ordinateur comprenant des instructions pour effectuer les étapes du procédé décrit ci-dessus lorsque ce programme est exécuté par un processeur.

Le procédé décrit ci-dessus peut ainsi être mis en oeuvre par des moyens numériques de traitement, par exemple un microprocesseur, un microcontrôleur ou autre.

Il est en outre proposé un dispositif d'estimation de la durée d'une phase de réhabilitation de la performance d'une batterie permettant d'amener ladite batterie dans des conditions d'état de charge et de température lui permettant de fournir un niveau de puissance minimal requis, ledit dispositif comprenant des moyens de mémorisation d'un modèle de fonctionnement de la batterie incluant, dans un plan (BSOC, T) où BSOC désigne l'état de charge de la batterie et où T désigne la température de la batterie, une courbe d'iso-puissance représentant dans ledit plan les points de fonctionnement de la batterie lui permettant de délivrer sensiblement ledit niveau de puissance minimal requis, ladite courbe séparant les points de fonctionnement permettant de délivrer un niveau de puissance supérieur au niveau de puissance minimal requis des points de fonctionnement ne lui permettant de délivrer qu'un niveau de puissance inférieur au niveau de puissance minimal requis, et des moyens de calcul aptes à estimer la durée de ladite phase de réhabilitation de la performance batterie à partir dudit modèle de fonctionnement fourni.

Il est en outre proposé un véhicule automobile comprenant un dispositif de détection tel que décrit ci-dessus.

D'autres particularités et avantages de l'invention ressortiront à la lecture de la description faite ci-après d'un mode de réalisation particulier de l'invention, donné à titre indicatif mais non limitatif, en référence aux dessins annexés sur lesquels :

- la Figure 1 illustre un modèle de fonctionnement de la batterie dans le plan température/état de charge, ledit modèle de fonctionnement comportant une courbe d'iso-puissance correspondant à un niveau de puissance minimal requis susceptible d'être fourni par ladite batterie;
- la Figure 2 est une figure analogue à la figure 1 montrant la mise en oeuvre de l'invention.

La description ci-après est faite dans le contexte de l'estimation de la durée d'une phase de charge de la batterie de traction d'un véhicule hybride équipé d'un groupe motopropulseur hybride comprenant un moteur thermique et au moins un moteur électrique, où la phase de charge de la batterie vise à assurer le « décollage » du véhicule à l'arrêt du véhicule au aux basses vitesses via le moteur électrique, dans le cas où la batterie de traction possède un état de charge trop faible pour fournir le niveau de puissance minimal requis permettant de « décoller » ledit véhicule.

A titre d'exemple, le niveau de puissance minimal requis peut être dimensionné pour répondre aux contraintes suivantes : lancer le véhicule au démarrage à l'aide du seul moteur électrique sur une pente normalisée jusqu'à atteindre une vitesse cible du véhicule de 10 km/h, à partir de laquelle le moteur thermique pourra intervenir. Selon ce cas de dimensionnement, le niveau de puissance minimal requis est fixé à au moins 5 kW.

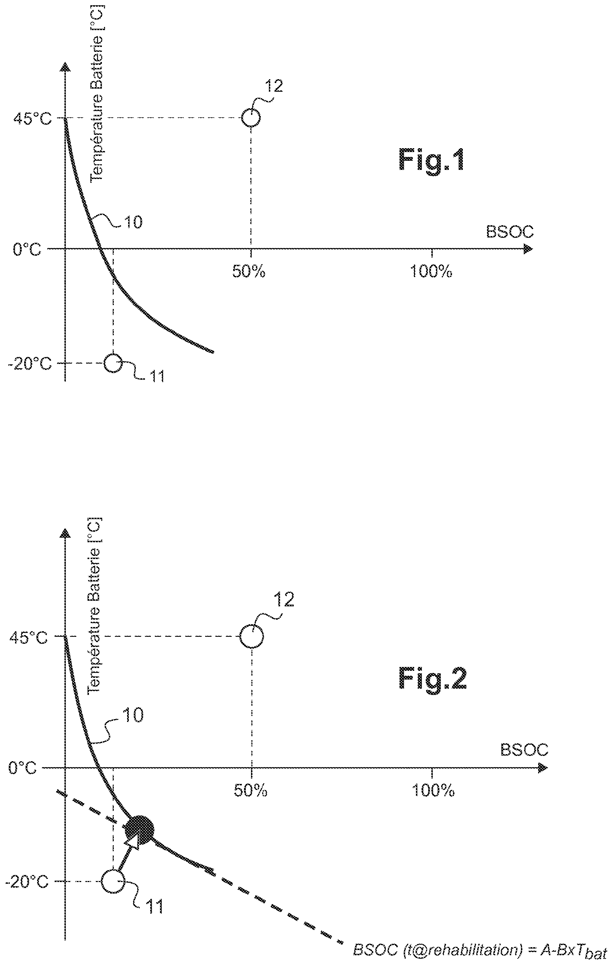

En référence à la figure 1, l'invention consiste à disposer d'un modèle de fonctionnement de la batterie dans le plan température/état de charge (BSOC) de la batterie, qui présente une portion qui s'étend sensiblement selon une courbe d'iso-puissance 10 tracée dans ce plan et correspondant au niveau de puissance minimal requis susceptible d'être fourni par ladite batterie, soit 20 kW selon le cas de dimensionnement donné plus haut à titre d'exemple. La courbe d'iso-puissance 10 est donc une courbe dans le plan température/état de charge de la batterie, le long de laquelle la puissance fournie par la batterie est constante et correspond au niveau de puissance minimal requis par le cas de dimensionnement prédéfini. Les points de fonctionnement de la batterie situés au-dessous de cette courbe d'iso-puissance 10 (état de charge ou température de batterie plus faible), par exemple le point 11, correspondent aux points de fonctionnement pour lesquels la batterie ne saura pas fournir le niveau de puissance minimal requis. Par conséquent, le conducteur sera potentiellement immobilisé temporairement. Par contre, les points de fonctionnement de la batterie situés au-dessus de la courbe d'iso-puissance 10 (état de charge ou température de batterie plus élevée), par exemple le point 12, correspondent aux points de fonctionnement pour lesquels la batterie saura fournir le niveau de puissance minimal requis.

Nous allons décrire dans un premier temps les équations qui caractérisent l'évolution de la température de la batterie ainsi que de l'état de charge, en phase de charge de la batterie.

Les variables qui seront utilisée dans la suite sont les suivantes :

$T_{BAT}$ : La température de la batterie - unité [°C]
$T_{ext}$ : La température extérieure - unité [°C]
$I_{BAT}$ : le courant qui traverse la batterie (positif en décharge, négatif en charge) - unité [A],
$BSOC$ : L'état de charge de la batterie (Battery State Of Charge) - unité [%],
$Q_{max}$ : La capacité totale de la batterie - unité [A.h.]
$C_p$ : La capacité calorifique de la batterie - unité [J/kg/K]
$m$ : La masse de la batterie - unité [kg]
$R$ : La résistance interne de la batterie - unité [Ohm]
$h$ : Le coefficient de convection entre la batterie et l'extérieur - unité [W/m$^2$/K]
$S$ : La surface d'échange avec l'extérieur - unité [m$^2$]
$\varepsilon$ : La création de chaleur par un système de chauffage - unité [W]

On définit en outre le terme suivant :

$$\tau = \frac{m \cdot C_p}{h \cdot S}$$

L'évolution de la température de la batterie est commandée par l'équation suivante :

$$m \cdot C_p \cdot \frac{\partial T_{BAT}}{\partial t} = R \cdot \left(I_{BAT}\right)^2 + \varepsilon - h \cdot S \cdot \left(T_{BAT} - T_{ext}\right) \qquad [1]$$

Par conséquent, à partir de l'instant $t_0$ correspondant à l'instant d'activation de la phase de charge de la batterie, si on fait l'hypothèse que $I_{BAT}$, $R, h, \varepsilon$ sont constants, on peut caractériser la montée en température de la batterie à chaque instant $t$ avec l'équation suivante :

$$T_{BAT}\left(t\right) = T_{BAT}\left(t_0\right) + \Theta \cdot \left(1 - e^{-\frac{(t-t_0)}{\tau}}\right), \text{ avec} \qquad [2]$$

$$\Theta = \frac{R \cdot (I_{BAT})^2 + \varepsilon}{h \cdot S} + T_{ext} - T_{BAT}(t_0) \qquad [3]$$

Par ailleurs, si on fait l'hypothèse que $I_{BAT}$ est constant (négatif en mode de charge), on peut alors estimer l'évolution de l'état de charge de la batterie $BSOC$ au cours du temps selon l'équation suivante :

$$BSOC(t) = BSOC(t_0) - \frac{I_{BAT}}{Q_{max}} \cdot (t - t_0) \qquad [4]$$

Grâce à la courbe d'iso-puissance 10 reportée dans le plan température/état de charge de la batterie, pour une température de batterie donnée, on peut donc définir un seuil $BSOC(t@rehabilitation)$ correspondant à l'état de charge pour lequel la batterie est apte à fournir le niveau de puissance minimal requis. Selon un mode de réalisation préférentiel illustré à la figure 2, on prend comme hypothèse le fait que ce seuil $BSOC(t@rehabilitation)$ dépend linéairement de la température de batterie. Aussi, on définit ce seuil en approchant la courbe d'iso-puissance 10 avec la tangente à la courbe d'iso-puissance par rapport à une température donnée, par exemple -15°C selon l'exemple de la figure 2. Ceci revient à linéariser localement la courbe d'iso-puissance 10 de manière à définir une droite d'iso-puissance correspondant au seuil d'état de charge $BSOC(t@rehabilitation)$ pour lequel la batterie sait fournir le niveau de puissance minimal requis. L'équation de cette droite est alors :

$$BSOC(t@rehabilitation) = A - B \times T_{BAT} \qquad [5]$$

Cette droite coupe l'axe $BSOC$ pour $BSOC = A$ et a pour pente $B$.

Sur cette base, à partir du point de fonctionnement 11 de la batterie, qui ne permet pas de faire « décoller » le véhicule au démarrage à l'aide du seul moteur électrique, la batterie étant dans un état où elle est incapable de fournir le niveau de puissance minimal requis, la durée de la phase de charge de la batterie permettant de l'amener dans un état lui permettant de fournir le niveau de puissance minimal requis, pourra être estimé comme étant le temps nécessaire pour amener le point de fonctionnement 11 de la batterie sur la courbe d'iso-puissance 10 approchée par la droite d'équation [5] ci-dessus.

Ce temps de réhabilitation de la puissance de la batterie résulte plus précisément de la mise en oeuvre des calculs suivants.

Dans le cas de la charge, en couplant tout d'abord les équations [2], [4] et [5] décrites ci-dessus, on obtient :

$$BSOC(t@rehabilitation) = BSOC(t_0) - \frac{I_{BAT}}{Q_{max}} \cdot (t@rehabilitation - t_0)$$

$$= A - B \times \left\{ T_{bat}(t_0) + \Theta \cdot \left( 1 - e^{-\frac{(t@rehabilitation - t_0)}{\tau}} \right) \right\}$$

Et finalement, on obtient la durée de la phase de charge permettant de réhabiliter les performances de la batterie de la façon suivante, partant d'un point de fonctionnement de la batterie à l'instant d'activation de la phase de charge, défini par $BSOC(t_0)$ et $T_{BAT}(t_0)$ :

$$(t@rehabilitation - t_0) = \frac{\left( BSOC(t_0) - A + B \cdot T_{Bat}(t_0) \right) Q_{max}}{I_{BAT} - \frac{\Theta \cdot B \cdot Q_{max}}{\tau}} \qquad [6]$$

Dans le cas d'une réhabilitation de la performance batterie sans charge (courant nul mais réchauffage présent), on obtient à partir de l'équation [2] :

$$\left(t @ rehabilitation - t_0\right) = -\tau \cdot \ln\left(1 - \frac{\frac{A - BSOC(t_0)}{B} - T_{bat}(t_0)}{\Theta}\right) \quad [7]$$

Pour ce faire, il est nécessaire de déterminer la valeur du courant appliqué à la batterie pendant la phase de charge. Le courant quadratique moyen pourra être considéré comme étant le carré de la valeur instantanée du courant pendant la phase de charge. Selon un autre mode de réalisation, on détermine cette valeur à partir d'une cartographie fournissant la valeur du courant quadratique moyen en fonction de l'état de charge et de la température de la batterie.

Aussi, selon un mode de réalisation préférentiel, on pourra calculer à chaque instant le temps de réhabilitation de la performance batterie à partir du calcul décrit par l'équation [6] ci-dessus.

Cette information quant à la durée du temps de réhabilitation de la performance batterie pourra avantageusement être indiquée au conducteur, par exemple au moyen d'un affichage appropriée au niveau du tableau de bord du véhicule. Ainsi, si le véhicule est par exemple immobilisé (vitesse nulle) et que la puissance disponible dans la batterie est inférieure à un seuil, alors, la phase de charge est activée en utilisant le moteur électrique en mode générateur et on indique sur le tableau de bord l'estimation de durée de la phase de charge calculée de la manière expliquée plus haut, correspondant au temps de réhabilitation de la performance batterie. C'est le temps que le conducteur devra attendre en bord de route pour permettre à la batterie de revenir dans des conditions d'état de charge et de température lui permettant d'assurer le niveau de puissance minimal requis.

Les moyens de calculs mis en oeuvre pour l'estimation de la durée de la phase de charge selon l'invention sont implémentés par un calculateur embarqué dans le véhicule, par exemple le calculateur de type BMS (Battery Management System), qui est le calculateur dédié et intégré à la batterie. De manière alternative, ces moyens de calculs pourraient être implémentés par un calculateur de plus haut niveau, par exemple un calculateur adapté pour contrôler le groupe motopropulseur du véhicule dans son ensemble, dans la mesure où cette estimation de durée pourrait dépendre d'informations externes complémentaires qui ne sont pas nécessairement disponibles au niveau du BMS (température extérieure, disponibilité du système de réchauffage de la batterie, etc.).

Revendications

1. Procédé d'estimation de la durée d'une phase de réhabilitation de la performance d'une batterie qui comprend des étapes de :

    - activation de la phase de réhabilitation de la performance batterie si la puissance disponible de la batterie est inférieure à un niveau de puissance minimal requis, ladite phase permettant d'amener ladite batterie dans des conditions d'état de charge et de température lui permettant de fournir ledit niveau de puissance minimal requis,
    - fourniture d'un modèle de fonctionnement de la batterie incluant, dans un plan BSOC-T où BSOC désigne l'état de charge de la batterie et où T désigne la température de la batterie, une courbe d'iso-puissance (10) représentant dans ledit plan les points de fonctionnement de la batterie lui permettant de délivrer sensiblement ledit niveau de puissance minimal requis, ladite courbe séparant les points de fonctionnement permettant de délivrer un niveau de puissance supérieur au niveau de puissance minimal requis des points de fonctionnement ne lui permettant de délivrer qu'un niveau de puissance inférieur au niveau de puissance minimal requis,
    - estimation de la durée de ladite phase de réhabilitation de la performance batterie à partir dudit modèle de fonctionnement fourni.

2. Procédé selon la revendication 1, **caractérisé en ce que** ladite phase de réhabilitation de la performance batterie consiste en une phase de charge de la batterie.

3. Procédé selon la revendication 2, **caractérisé en ce que** l'étape d'estimation de la durée de la phase de charge comprend des étapes de :

    - déterminer la valeur du courant fourni à la batterie pendant ladite phase de charge ;
    - à partir d'un point de fonctionnement (11) de la batterie défini par la température de la batterie et l'état de charge de la batterie à l'instant d'activation de la phase de charge, ledit point de fonctionnement ne permettant de délivrer qu'un niveau de puissance inférieur au niveau minimal requis, déterminer, en fonction dudit courant fourni à la batterie, la durée de ladite phase de charge comme étant le temps nécessaire pour amener le point de fonctionnement de la batterie sur ladite courbe d'iso-puissance (10).

4. Procédé selon la revendication 3, **caractérisé en ce qu'**il comprend l'étape de linéariser localement ladite courbe d'iso-puissance de façon à définir un seuil d'état de charge *BSOC*(*t@rehabilitation*) variant linéairement avec la température de batterie pour lequel la batterie est apte à fournir ledit niveau de puissance minimal requis, la durée de ladite phase de charge étant déterminée par rapport à ce seuil d'état de charge.

5. Procédé selon l'une quelconque des revendications 2 à 4, **caractérisé en ce que** la batterie est une batterie de traction d'un véhicule hybride comprenant un moteur thermique et au moins un moteur électrique, et **en ce que** ladite phase de charge est réalisée en utilisant ledit au moins un moteur électrique en mode générateur.

6. Procédé selon la revendication 5, **caractérisé en ce que** ledit niveau de puissance minimal requis correspond à la puissance de traction requise pour assurer le lancement du véhicule à partir de l'arrêt et aux basses vitesses de déplacement du véhicule jusqu'à une vitesse de véhicule cible prédéterminée.

7. Procédé selon l'une quelconque des revendications précédentes, **caractérisé en ce qu'**il comprend l'étape d'afficher la durée estimée de ladite phase de de réhabilitation de la performance batterie.

8. Dispositif d'estimation de la durée d'une phase de réhabilitation de la performance d'une batterie permettant d'amener ladite batterie dans des conditions d'état de charge et de température lui permettant de fournir un niveau de puissance minimal requis, ledit dispositif comprenant des moyens de mémorisation d'un modèle de fonctionnement de la batterie incluant, dans un plan BSOC-T où BSOC désigne l'état de charge de la batterie et où T désigne la température de la batterie, une courbe d'iso-puissance (10) représentant dans ledit plan les points de fonctionnement de la batterie lui permettant de délivrer sensiblement ledit niveau de puissance minimal requis, ladite courbe séparant les points de fonctionnement permettant de délivrer un niveau de puissance supérieur au niveau de puissance minimal requis des points de fonctionnement ne lui permettant de délivrer qu'un niveau de puissance inférieur au niveau de puissance minimal requis, et des moyens de calcul aptes à estimer la durée de ladite phase de charge à partir dudit modèle de fonctionnement fourni.

9. Véhicule automobile **caractérisé en ce qu'**il comprend un dispositif d'estimation selon la revendication 8.

**Patentansprüche**

1. Verfahren zur Schätzung der Dauer einer Phase der Wiederherstellung der Leistungsfähigkeit einer Batterie, welches folgende Schritte umfasst:

- Aktivierung der Phase der Wiederherstellung der Leistungsfähigkeit der Batterie, falls die verfügbare Leistung der Batterie niedriger als ein erforderlicher minimaler Leistungspegel ist, wobei diese Phase ermöglicht, die Batterie in Bedingungen des Ladezustands und der Temperatur zu versetzen, die es ihr ermöglichen, den erforderlichen minimalen Leistungspegel zu liefern,
- Bereitstellung eines Funktionsmodells der Batterie, welches in einer BSOC-T-Ebene, wobei BSOC den Ladezustand der Batterie bezeichnet und wobei T die Temperatur der Batterie bezeichnet, eine Kurve gleicher Leistung (10) aufweist, welche in dieser Ebene die Betriebspunkte der Batterie darstellt, die es ihr ermöglichen, im Wesentlichen den erforderlichen minimalen Leistungspegel zu liefern, wobei die Kurve die Betriebspunkte, die es ermöglichen, einen Leistungspegel zu liefern, der höher als der erforderliche minimale Leistungspegel ist, von den Betriebspunkten trennt, die es ihr nur ermöglichen, einen Leistungspegel zu liefern, der niedriger als der erforderliche minimale Leistungspegel ist,
- ausgehend von dem bereitgestellten Funktionsmodell, Schätzung der Dauer der Phase der Wiederherstellung der Leistungsfähigkeit der Batterie.

2. Verfahren nach Anspruch 1, **dadurch gekennzeichnet, dass** die Phase der Wiederherstellung der Leistungsfähigkeit der Batterie aus einer Ladephase der Batterie besteht.

3. Verfahren nach Anspruch 2, **dadurch gekennzeichnet, dass** der Schritt der Schätzung der Dauer der Ladephase folgende Schritte umfasst:

- Bestimmen des Wertes des Stroms, welcher der Batterie während der Ladephase zugeführt wird;

- ausgehend von einem Betriebspunkt (11) der Batterie, der durch die Temperatur der Batterie und den Ladezustand der Batterie zum Zeitpunkt der Aktivierung der Ladephase definiert ist, wobei dieser Betriebspunkt es nur ermöglicht, einen Leistungspegel zu liefern, der niedriger als der erforderliche minimale Pegel ist, Bestimmen, in Abhängigkeit von dem der Batterie zugeführten Strom, der Dauer der Ladephase als die Zeit, die erforderlich ist, um den Betriebspunkt der Batterie auf die Kurve gleicher Leistung (10) zu verlagern.

4. Verfahren nach Anspruch 3, **dadurch gekennzeichnet, dass** es den Schritt der lokalen Linearisierung der Kurve gleicher Leistung umfasst, um einen sich linear mit der Temperatur der Batterie ändernden Ladezustandsschwellenwert *BSOC(t@rehabilitation)* zu definieren, für welchen die Batterie in der Lage ist, den erforderlichen minimalen Leistungspegel zu liefern, wobei die Dauer der Ladephase in Bezug auf diesen Ladezustandsschwellenwert bestimmt wird.

5. Verfahren nach einem der Ansprüche 2 bis 4, **dadurch gekennzeichnet, dass** die Batterie eine Traktionsbatterie eines Hybridfahrzeugs ist, das einen Verbrennungsmotor und wenigstens einen Elektromotor umfasst, und dadurch, dass die Ladephase durchgeführt wird, indem der wenigstens eine Elektromotor im Generatormodus betrieben wird.

6. Verfahren nach Anspruch 5, **dadurch gekennzeichnet, dass** der erforderliche minimale Leistungspegel der Traktionsleistung entspricht, die zum Sicherstellen des Startens des Fahrzeugs aus dem Stillstand und bei den niedrigen Fahrgeschwindigkeiten des Fahrzeugs bis zu einer vorbestimmten Zielgeschwindigkeit des Fahrzeugs erforderlich ist.

7. Verfahren nach einem der vorhergehenden Ansprüche, **dadurch gekennzeichnet, dass** es den Schritt des Anzeigens der geschätzten Dauer der Phase der Wiederherstellung der Leistungsfähigkeit der Batterie umfasst.

8. Vorrichtung zur Schätzung der Dauer einer Phase der Wiederherstellung der Leistungsfähigkeit einer Batterie, die es ermöglicht, die Batterie in Bedingungen des Ladezustands und der Temperatur zu versetzen, die es ihr ermöglichen, einen erforderlichen minimalen Leistungspegel zu liefern, wobei die Vorrichtung Mittel zur Speicherung eines Funktionsmodells der Batterie umfasst, welches in einer BSOC-T-Ebene, wobei BSOC den Ladezustand der Batterie bezeichnet und wobei T die Temperatur der Batterie bezeichnet, eine Kurve gleicher Leistung (10) aufweist, welche in dieser Ebene die Betriebspunkte der Batterie darstellt, die es ihr ermöglichen, im Wesentlichen den erforderlichen minimalen Leistungspegel zu liefern, wobei die Kurve die Betriebspunkte, die es ermöglichen, einen Leistungspegel zu liefern, der höher als der erforderliche minimale Leistungspegel ist, von den Betriebspunkten trennt, die es ihr nur ermöglichen, einen Leistungspegel zu liefern, der niedriger als der erforderliche minimale Leistungspegel ist, und Berechnungsmittel, die in der Lage sind, ausgehend von dem bereitgestellten Funktionsmodell die Dauer der Ladephase zu schätzen.

9. Kraftfahrzeug, **dadurch gekennzeichnet, dass** es eine Vorrichtung zur Schätzung nach Anspruch 8 umfasst.

**Claims**

1. Method for estimating the duration of a battery performance rehabilitation phase, which comprises steps of:

   - activating the battery performance rehabilitation phase if the power available in the battery is below a required minimum power level, said phase making it possible to bring said battery to state-of-charge and temperature conditions enabling it to supply said required minimum power level,
   - supplying a model of operation of the battery including, in a plane BSOC-T where BSOC denotes the state of charge of the battery and where T denotes the temperature of the battery, an isopower curve (10) representing, in said plane, the operating points of the battery enabling it to substantially deliver said required minimum power level, said curve separating the operating points making it possible to deliver a power level above the required minimum power level from the operating points enabling it to deliver only a power level below the required minimum power level,
   - estimating the duration of said battery performance rehabilitation phase from said model of operation supplied.

2. Method according to Claim 1, **characterized in that** said battery performance rehabilitation phase consists of a battery charging phase.

3. Method according to Claim 2, **characterized in that** the step of estimating the duration of the charging phase comprises steps of:

- determining the value of the current supplied to the battery during said charging phase;
- from an operating point (11) of the battery defined by the temperature of the battery and the state of charge of the battery at the instant of activation of the charging phase, said operating point allowing it to deliver only a power level below the required minimum level, determining, as a function of said current supplied to the battery, the duration of said charging phase as being the time needed to bring the operating point of the battery to said isopower curve (10).

4. Method according to Claim 3, **characterized in that** it comprises the step of locally linearizing said isopower curve so as to define a state-of-charge threshold *BSOC(t@rehabilitation)* varying linearly with the battery temperature for which the battery is able to supply said required minimum power level, the duration of said charging phase being determined relative to this state-of-charge threshold.

5. Method according to any one of Claims 2 to 4, **characterized in that** the battery is a traction battery of a hybrid vehicle, comprising a heat engine and at least one electric motor, and **in that** said charging phase is carried out by using said at least one electric motor in generator mode.

6. Method according to Claim 5, **characterized in that** said required minimum power level corresponds to the traction power required to ensure the take-off of the vehicle from stopped and at low speeds of displacement of the vehicle up to a predetermined target vehicle speed.

7. Method according to any one of the preceding claims, **characterized in that** it comprises the step of displaying the estimated duration of said battery performance rehabilitation phase.

8. Device for estimating the duration of a battery performance rehabilitation phase, making it possible to bring said battery into state-of-charge and temperature conditions enabling it to supply a required minimum power level, said device comprising means for storing a model of operation of the battery including, in a plane BSOC-T where BSOC denotes the state of charge of the battery and where T denotes the temperature of the battery, an isopower curve (10) representing, in said plane, the operating points of the battery enabling it to substantially deliver said required minimum power level, said curve separating the operating points making it possible to deliver a power level above the required minimum power level from the operating points enabling it to deliver only a power level below the required minimum power level, and computation means capable of estimating the duration of said charging phase from said model of operation supplied.

9. Motor vehicle, **characterized in that** it comprises an estimation device according to Claim 8.

Fig.1

Fig.2

$$BSOC\ (t@rehabilitation) = A - B \times T_{bat}$$

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2992274

- US 5945808 A